# EUROPEAN PATENT APPLICATION

(11) **EP 1 739 740 A2**
(43) Date of publication of application: **03.01.2007**
(21) Application number: 06013397.2
(22) Date of filing: 28.06.2006
(51) Int. Cl.: H01L 23/26

(54) **Power semiconductor**

(30) Priority: 30.06.2005 JP 2005190869
(71) Applicant: HITACHI, LTD., Chiyoda-ku Tokyo 100-8280 (JP)
(72) Inventor: Koike, Yoshihiko c/o Hitachi, Ltd., Chiyoda-ku Tokyo 100-8220 (JP); Okubo, Shinji c/o Hitachi Haramachi Electronics Co, Hitachi-shi Ibaraki 317-0072 (JP); Toyoda, Yasushi c/o Hitachi, Ltd., Chiyoda-ku Tokyo 100-8220 (JP); Saito, Katsuaki c/o Hitachi, Ltd., Chiyoda-ku Tokyo 100-8220 (JP); Hayakawa, Seiichi c/o Hitachi, Ltd., Chiyoda-ku Tokyo 100-8220 (JP)
(74) Representative: Strehl Schübel-Hopf & Partner

(57) **Abstract**

A power semiconductor is provided in which the life of a joint between a metal wire and a semiconductor element is extended and the insulation tolerance of an insulating substrate is improved. In the power semiconductor of the present invention, a peripheral surface portion of an insulating substrate where a metal circuit is not joined and a joint interface portion between a semiconductor element and a metal wire are coated with an electrically insulating resin having (1) a smaller coefficient of expansion, (2) a larger Young's modulus and (3) higher insulation tolerance than a resin which is filled in order to ensure the insulation of the whole module, and the thickness of the coated resin is selected so that an inflection point of the coating resin in the direction of the wire section becomes not more than 1/4 of the section height of the wire.

## Description

### BACKGROUND OF THE INVENTION

### Field of the Invention

The present invention relates to a power semiconductor and, more particularly, to a module structure of a high breakdown voltage semiconductor in which high reliability has been achieved with high capacitance.

### Description of the Related Art

There has hitherto been known a power semiconductor (a power semiconductor module) which is constructed by sealing power semiconductor elements, such as IGBT, diode and GTO, in an insulated container. These elements are used in various kinds of inverter devices according to the breakdown voltage and current capacity of the elements. Among others, an IGBT element has the advantages that it is a voltage controlled element and is easily controlled, that large-current, high-frequency operation is possible, and the like. Also, in many cases, these elements have such a construction that a metal substrate on the bottom surface of a module and a current conducting portion are electrically insulated form each other within the module, and they are easily mounted in inverter devices. Therefore, the range of application of these elements has been rapidly becoming wider.

The basic construction of these semiconductors is such that semiconductor elements are mounted on an insulating substrate within a module and the number of semiconductor elements in parallel arrangement within the module is increased according to current capacity. The elements mounted on the insulating substrate are connected to a metal foil circuit on the insulating substrate by use of aluminum wires. During the driving of the module, the semiconductor elements repeat heat generation and cooling. At this time, at the interface with an aluminum wire joined on a semiconductor element, stresses are concentrated due to a difference in the coefficient of linear expansion of each member (Si: 3 ppm/°C, Al: 22 ppm/°C) due to a temperature change and cracks occur in the interface portion of the wire. The cracks propagate when the driving period becomes long, and eventually exfoliation occurs between the semiconductor element and the aluminum wire.

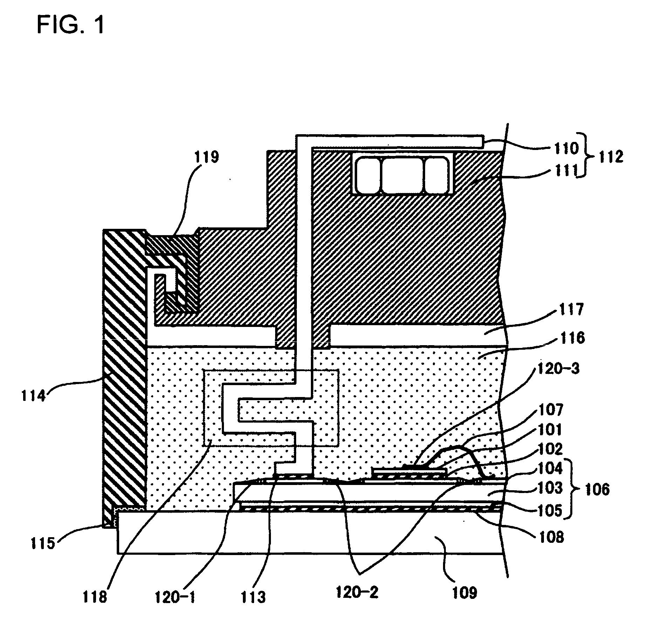

In order to reduce these stresses, as shown in Japanese Patent Laid-Open No. 10-32218 (described in FIG. 1 and paragraph (0013)), the life of a joint has thitherto been extended by ensuring that the joint position of the aluminum wire is positioned in a peripheral portion, i.e. , in a portion of small temperature change within the semiconductor element.

On the other hand, the insulation within the module is determined by the thickness of the insulating substrate and the creepage distance of the peripheral portion of the insulating substrate. When a power semiconductor module is used in applications requiring high insulation tolerance, it has been general practice to increase the thickness of the insulating substrate and to lengthen the creepage distance.

The above prior art has the following problems. In order to extend the life of an aluminum wire, the aluminum wire joint is arranged at the peripheral portion of the semiconductor chip. However, when the current capacity of the semiconductor element increases, it becomes necessary to increase the number of aluminum wires because there is an upper limit to the current density per aluminum wire. Hence, with the joining of the peripheral portion of the IGBT chip alone, the prior art suffers from a design limitation. When wires are similarly arranged only in the peripheral portion in the case of a backflow diode chip, the spacing of wire joints on the chip increases, thereby posing the problem that a current flowing on an electrode film on the semiconductor element increases before it reaches the wires, resulting in a decrease in the maximum allowable current (surge current) tolerance during malfunctions.

When the insulating substrate thickness is increased in order to improve insulation tolerance, the cooling effect of the semiconductor element decreases, thereby increasing the thermal resistance of the module, with the result that the semiconductor element temperature during driving rises, shortening the life of the element. If the creepage distance is widened to improve insulation tolerance, the area occupied by the insulating substrate within the module increases to produce constraints to the layout of the interior of the module, and this may be an obstacle to the generation of large currents by the arrangement of semiconductor elements in parallel.

The object of the present invention is to provide a power semiconductor in which the life of a joint between a metal wire and a semiconductor element is extended and the insulation tolerance of an insulating substrate is improved.

### SUMMARY OF THE INVENTION

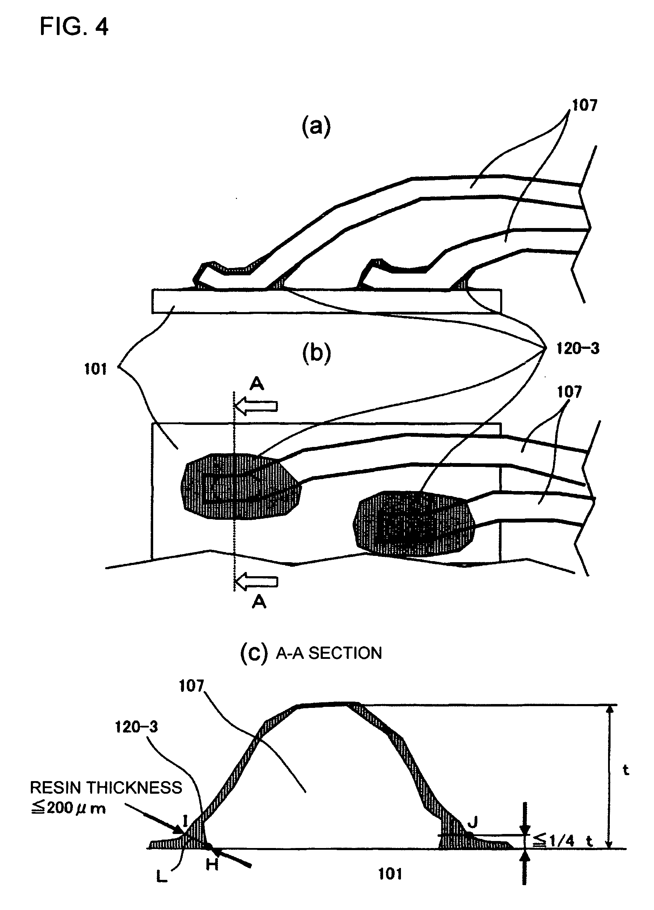

To solve the above problems, in a power semiconductor of the present invention, a peripheral surface portion of an insulating substrate where a metal circuit is not joined and a joint interface portion between a semiconductor element and a metal wire are coated with an electrically insulating resin having (1) a smaller coefficient of expansion, (2) a larger Young's modulus and (3) higher insulation tolerance than a resin which is filled in order to ensure the insulation of the whole module, and the thickness of the resin is selected so that the spacing between an inflection point of the coating resin in the direction of the wire section, i.e., a point at which the orientation of the topography of the coating resin changes and the semiconductor element becomes not more than 1/4 of the section height of the wire (t in FIG. 4 (c)).

In a power semiconductor of the present invention, a joint between a semiconductor element and an aluminum wire is coated with a first insulating resin having electrically conductive properties, whereby the life of the semiconductor element is improved. By coating a peripheral surface portion of an insulating substrate with the first resin, it is possible to obtain high electrically insulating properties in a stable manner and hence it is possible to reduce the thickness of the insulating substrate to about 1/2 if the insulation tolerance is the same, with the result that it is possible to lower thermal resistance.

### BRIEF DESCRIPTION OF THE DRAWINGS

FIG. 1 is a sectional view of a power semiconductor module of Embodiment 1;
FIG. 2 is a plan view to explain the coating on the insulating substrate of the power semiconductor module of Embodiment 1;
FIG. 3 is a sectional view to explain the coating on the insulating substrate of the power semiconductor module of Embodiment 1;
FIG. 4 is a diagram to explain the coating on the aluminum wire of the power semiconductor module of Embodiment 1;
FIG. 5 is a diagram to explain calculation results of the relationship between the Young's modulus and strains of a coating resin of the power semiconductor module of Embodiment 1;
FIG. 6 is a diagram to explain a life test on the power semiconductor module of Embodiment 1;
FIG. 7 is an explanatory diagram when the coating on the aluminum wire is thick in the power semiconductor module of Embodiment 1;
FIG. 8 is an explanatory diagram of a power semiconductor module of Embodiment 2; and
FIG. 9 is an explanatory diagram of another power semiconductor module of Embodiment 2.

### DETAILED DESCRIPTION OF THE PREFERRED EMBODIMENTS

In a power semiconductor of the present invention, an interface between a semiconductor element and an aluminum wire is coated with a first insulating resin having electrically conductive properties to improve the joint life of the metal wire, making it possible to improve the life of the module. Also, by coating a terminal end of a metal circuit foil of the insulating substrate with the first resin, it becomes possible to improve also the insulation tolerance of the module. Details of the present invention will be given below with reference to the drawings.

### Embodiment 1

FIG. 1 is a sectional view of part of an IGBT module, which is a power semiconductor module of this embodiment. In FIG. 1, the reference numeral 101 denotes a semiconductor element, such as an IGBT chip and a diode chip, the reference numeral 102 denotes a solder under the chip, the reference numeral 103 denotes an insulating substrate, the reference numerals 104 and 105 each denotes a metal circuit foil, the reference numeral 106 denotes an insulating circuit substrate, the reference numeral 107 denotes an aluminum wire which is a metal wire, the reference numeral 108 denotes a solder under the insulating circuit substrate, the reference numeral 109 denotes an electrically conductive base of metal and the like, the reference numeral 110 denotes a terminal, the reference numeral 111 denotes a terminal block resin, the reference numeral 112 denotes a terminal block, the reference numeral 113 denotes a solder under the terminal, the reference numeral 114 denotes a resin case, the reference numeral 115 denotes an adhesive, the reference numeral 116 denotes a second resin, the reference numeral 117 denotes a space portion in the interior of the module, and the reference numeral 118 denotes a stress-relieving bend.

As shown in FIG. 1, in order to ensure the insulating properties in the interior of the module, the semiconductor element 101 is joined to the insulating circuit substrate 106, in which the metal circuit foils 104, 105 are joined to top and bottom surfaces of the insulating substrate 103 made of ceramics, for example, AlN, alumina and SiN, by use of the solder under the chip 102. In order to increase the current capacity of the IGBT module, multiple semiconductor elements 101 are mounted on the same insulating circuit substrate 106 to increase the number of elements working in parallel within the same module.

In the IGBT module of this embodiment, after the joining of the semiconductor element 101 to the insulating circuit substrate 106, for example, a polyamideimide resin, which is the first resin 120, is applied to a peripheral surface portion of the insulating circuit substrate 106 and to an interspace in the metal circuit foil 104, and is caused to cure. Because this polyamideimide resin is a resin having electrically insulating properties (hereinafter simply called insulating properties), a deterioration in insulation tolerance does not occur even when this polyamideimide resin is applied to a peripheral surface portion of the insulating circuit substrate 106 and to the interspace in the metal circuit foil 104.

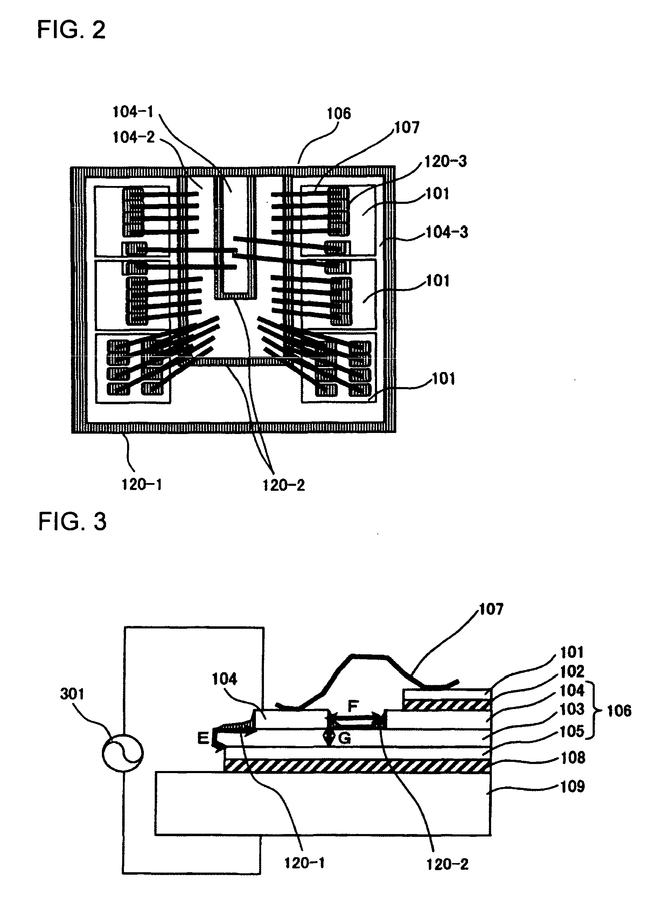

FIG. 2 is a plan view of a peripheral surface portion of the insulating circuit substrate 106 to which a polyamideimide resin 120-1 is applied, and FIG. 3 is a sectional view containing the base 109 and the like. Regions on the insulating circuit substrate 106 which require insulation tolerance are a peripheral surface portion (E) of the insulating circuit substrate 106 which requires insulation tolerance when voltage is applied by use of a test power supply 301 to an area between an external terminal 110 (omitted in FIG. 3) of the module and the base 109 of the back surface of the module, an area between a gate circuit 104-1 and an emitter circuit 104-2 where a voltage difference is generated during the driving of the module, and an area (F) between the emitter circuit 104-2 and a collector circuit 104-3. The insulation tolerance between the metal circuit foils is determined by the rated voltage of the module. In a case where the insulating substrate 103 is thin, however, also during the inspection of the insulating properties between the terminal 110 and the base 109, also between the metal circuit foil 104 on the side where the semiconductor element 101 is mounted and the metal circuit foil 105 on the back side, due to an electric field (G) generated via the insulating substrate 103, portions where the electric field is concentrated, for example, projections occurring due to nonuniform etching may sometimes be present in the metal circuit foil 104 on the side where the semiconductor element is mounted, and in such a case, a deterioration of the second resin 116 (not shown in FIG. 3) which coats the insulating substrate 103 occurs, resulting in the occurrence of a partial discharge. Although the occurrence of this partial discharge does not directly lead to dielectric breakdown, this is a condition predictive of breakdown. When the deterioration of resin proceeds, this results in dielectric breakdown and hence it is necessary to prevent discharge. For this reason, it is effective to apply a polyamideimide resin 120-2, which is the first resin, also to the interspace in the metal circuit foil 104.

After the application of the polyamideimide resins 120-1 and 120-2, an interconnection between the semiconductor element 101 and the metal circuit foil 104 is formed by using, for example, several aluminum wires 107 of φ 400 µm. After the formation of the interconnection, a polyamideimide resin 120-3 is applied to a joint portion between the semiconductor element 101 and the aluminum wire 107, and is caused to cure. Details of this applied portion are shown in FIG. 4. The region requiring the application of the polyamideimide resin 120-3 becomes a joint portion of the semiconductor element 101 and the aluminum wire 107 where the difference in the coefficient of linear expansion of the joint portion is great. The thickness of the applied resin is 20 to 200 µm, and these values have an effect sufficient for being able to suppress stresses due to the difference in the coefficient of linear expansion between the semiconductor element 101 which is made of Si and the aluminum wire 107. As shown in the sectional view of FIG. 4(c), "the thickness of the applied resin" is the distance L measured from a corner portion H where the semiconductor element 101 and the aluminum wire 107 are joined together to the nearest point (I) of the surface of the polyamideimide resin 120-3, which is the first resin.

Incidentally, because the application of the polyamideimide resin 120-3 to the surface of the semiconductor element 101 does not affect the element properties, there is no problem even when the polyamideimide resin 120-3 is applied to the whole surface of the semiconductor element 101 or to the metal circuit foil 104 on the insulating circuit substrate 106 on which the semiconductor element 101 is mounted.

In the IGBT module of this embodiment, the material for the resin applied to the interface between the semiconductor element 101 and the aluminum wire 107 and to the peripheral surface portion of the insulating substrate 103 is a polyamideimide resin common to both. Therefore, it is possible to adopt a method which involves one coat followed by curing, in which after the joining of the aluminum wire 107 to the semiconductor element 101, the viscosity of the polyamideimide resin is lowered by adding a solvent and the like, and this resin is applied to the interface between the semiconductor element 101 and the aluminum wire 107 and to the whole surface of the insulating substrate 103, whereby the applied resin is caused to spread to the peripheral surface portion between the metal circuit foil 104 and the insulating substrate 103 under the aluminum wire 7.

The insulating circuit substrate 106 to which the polyamideimide resin is applied is joined to the base 109, which is formed from a composite material made of, for example, oxygen-free copper, copper alloy, Al-SiC and Cu-Mo, by use of the solder under the insulating circuit substrate 108. The terminal block 112, in which the terminal 110 for external interconnection connected to a circuit within the module and the terminal block resin 111 which constitutes a cover are integrally formed, is set, and the terminal 110 and the insulating circuit substrate 106 are joined together by use of the solder under the terminal 113. Ni-coated oxygen-free copper, copper alloy and the like, which have small electric resistance and large thermal conductivity, are used as the material for the terminal 110 of these structures.

Next, the resin case 114 which constitutes the periphery of the IGBT module is joined to the base 109 by use of the adhesive 115, and a silicone gel, which is the second resin 116, is injected in order to ensure the insulation of the semiconductor element 101 within the module, the aluminum wire 107 and the terminal 110. At this time, in order to absorb the thermal expansion within the resin case 114 of the silicone gel, which is the second resin 116, the space portion 117 is provided on the top surface of the interior of the module. Lastly, in order to ensure the airtightness within the module, the area between the terminal block resin 111 and the resin case 114 is hermetically sealed by use of an adhesive 119, whereby the semiconductor is completed.

The values of physical properties of the first and second resins used in this embodiment are shown in Table 1.

**Table 1**

| No. | Item | First resin | Second resin |
|---|---|---|---|
| 1 | Material | Polyamideimide resin | Silicone gel |
| 2 | Coefficient of linear expansion | 500 ppm/°C | 300 ppm/°C |
| 3 | Young's modulus | 2800 MPa | 0.004 MPa |
| 4 | Insulation tolerance | 230 kV/mm | 15 kV/mm |

In order to suppress strains due to the difference in the coefficient of linear expansion between the semiconductor element 101 and the aluminum wire 107, the first resin requires Young's modulus values of 1500 MPa to 5000 MPa. It is preferred that the coefficient of linear expansion of the first resin be in the range of 40 ppm/°C to 60 ppm/°C. If the coefficient of linear expansion of the first resin is smaller or larger than these values, strains of the semiconductor element 101 and the aluminum wire 107 increase. Therefore, this is undesirable. Furthermore, because the first resin may sometimes directly coat projections due to nonuniform etching where electric fields are concentrated, and the like, it is preferred that the insulation tolerance be not less than 100 KV rms/mm. In this embodiment, it is preferred that the Young's modulus of the second resin be not more than 1 MPa, which is smaller than Young's modulus of the first resin, and that the coefficient of linear expansion of the second resin be in the range of 200 ppm/°C to 500 ppm/°C. If the coefficient of linear expansion of the second resin is smaller or larger than these values, strains occur at the interface with the first resin and cracks and the like may sometimes occur. Therefore, this is undesirable. Furthermore, because the second resin rarely coats projections directly due to nonuniform etching where electric fields are concentrated, and the like, and is disposed on the first resin, it is preferred that the insulation tolerance of the second resin be in the range of 10 to 30 KV rms/mm. If the insulation tolerance of the second resin is higher than the insulation tolerance of the first resin, this does not contribute to an improvement in the insulation tolerance of the whole module.

As described above, the first resin used in this embodiment is a resin having high insulation tolerance and, therefore, high insulation tolerance is obtained when the first resin is applied to the peripheral surface portion of the insulating substrate. Although the above description was given of the case where a polyamideimide resin is used as the first resin, similar effects can be obtained by using a polyamide resin, an epoxy resin and the like so long as these resins have values of physical properties in the ranges shown in Table 1.

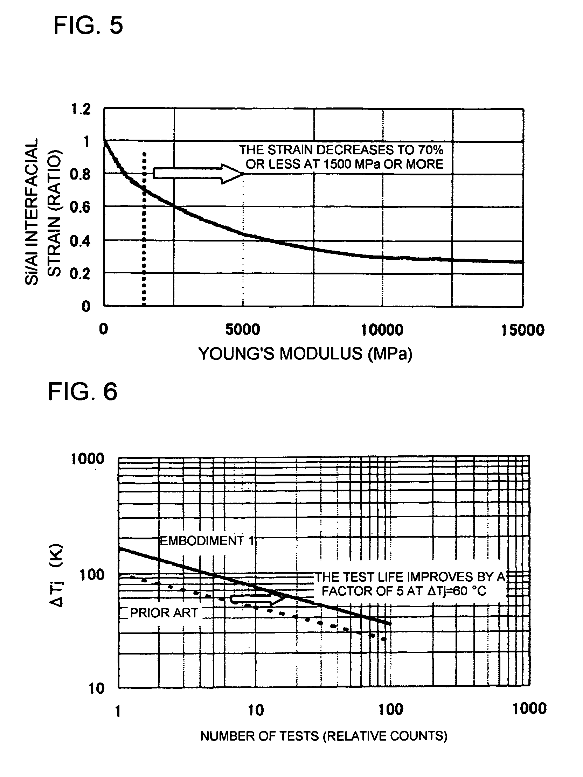

FIG. 5 shows calculation results of strains which occur during the driving of the semiconductor element 101 in a case where the joint between the semiconductor element 101 and the aluminum wire 107 is coated with resins having different Young's modulus values. From FIG. 5 it is apparent that when the periphery of the aluminum wire 107 is coated with a resin having a large Young's modulus (a hard resin), strains in the joint decrease, making it possible to achieve the extension of the life of the joint.

FIG. 6 shows results of a power cycle test on the resin-coated IGBT module of this embodiment in which the driving conditions are simulated. It could be ascertained that in the IGBT module of this embodiment, the dielectric breakdown tolerance is improved to about five times that of an IGBT module of prior art without the resin coating.

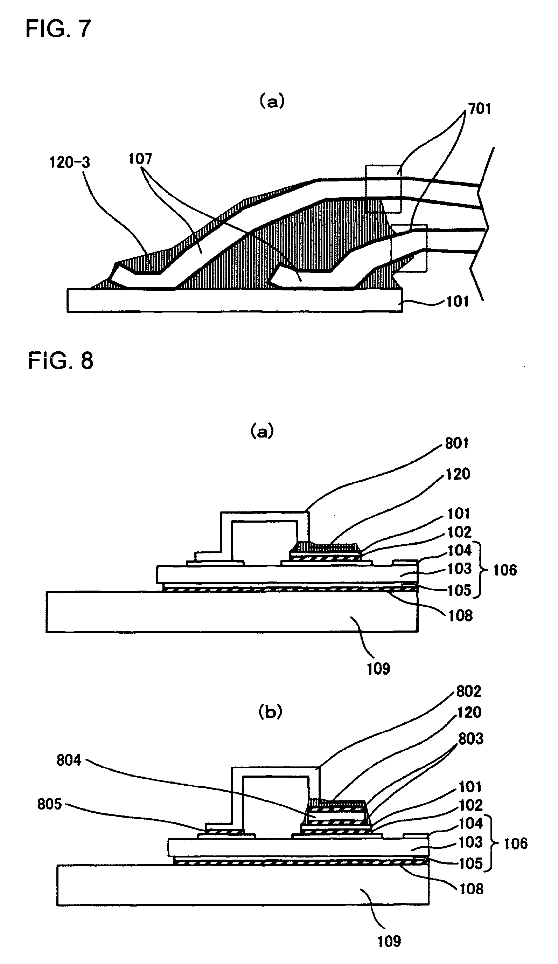

FIG. 7 shows a sectional view of the IGBT module of this embodiment when the thickness of the first resin 120-3 is large. If the aluminum wire 107 is coated with the first resin in a large coating thickness, stresses are concentrated at an interface 701 between the first resin coating portion and the second resin coating portion and there is a possibility that the wire may be broken in this part. For this reason, it is necessary to ensure that the coating thickness of the first resin 120-3 be not larger than required. Conversely, if the whole aluminum wire can be coated with the first resin, it is possible to suppress the deformation of the whole wire and hence it is possible to improve the life of the semiconductor element. However, as shown in FIG. 1, in a structure which requires the stress-relieving bend 118 to relieve stresses in the main terminal because of the large capacitance, the bow of the whole module increases if the whole module is filled with a resin having a large coefficient of linear expansion and a large Young's modulus. Therefore, this results in the occurrence of cracks in the insulating substrate, an increase in the contact thermal resistance due to an increase in the grease thickness during the mounting of the module, and the like. For these reasons, it is desirable that the thickness of the resin in the portion where the joint interface of the metal wire is coated be selected so that the spacing between an inflection point of the coating resin in the direction of the wire section, i.e., a point at which the orientation of the topography of the coating resin changes and the semiconductor element becomes not more than 1/4 of the section height of the wire (t in FIG. 4 (c)). If the position of this inflection point is at a height which is not less than 1/4, the first resin shown in FIG. 4 (c) becomes thin and it is impossible to raise the reliability of the joint between the semiconductor element and the aluminum wire. It is good if the spacing between the inflection point and the semiconductor element, which depends on the surface tension during the coating with the first resin, is in the range of 1/4 to 1/10 with respect to the section height of the wire (t in FIG. 4 (c)), and this spacing is sufficient if it is preferably in the range of 1/5 to 1/10.

### Embodiment 2

FIG. 8 shows an embodiment in which the resin coating of the present invention is applied to a member other than the metal wire of the semiconductor power module. The IGBT module of this embodiment differs from that of Embodiment 1 in that a metal ribbon 801 is provided in place of the aluminum wire 107 of Embodiment 1, and is the same as that of Embodiment 1 in other respects. In a power semiconductor module, also in a case where a member other than a metal wire, for example, a metal ribbon 801 formed from an Al material is joined by ultrasonic waves, the Al/Si joint interface may sometimes deteriorate due to thermal-stress strains by the same mechanism as when joining with the aluminum wire 107 is performed in Embodiment 1. Therefore, by coating with the first resin 120 as show in FIG. 8(a), it is possible to extend the life of the module in the same way as in Embodiment 1.

Furthermore, as shown in FIG. 8 (b), also in a case where a metal electrode 802 is joined via solders 803, 805 and a stress-relieving plate 804 by means other than ultrasonic joining, the solder 803 portion of the electrode deteriorates fastest because of great temperature changes during the driving of the semiconductor element 101 and great stress difference between the solder 803 and the semiconductor element 101. Also in this case, by coating the joint portion of the solder 803 with the first resin 120, it is possible to extend the life of the module by suppressing the deterioration of the solder 803.

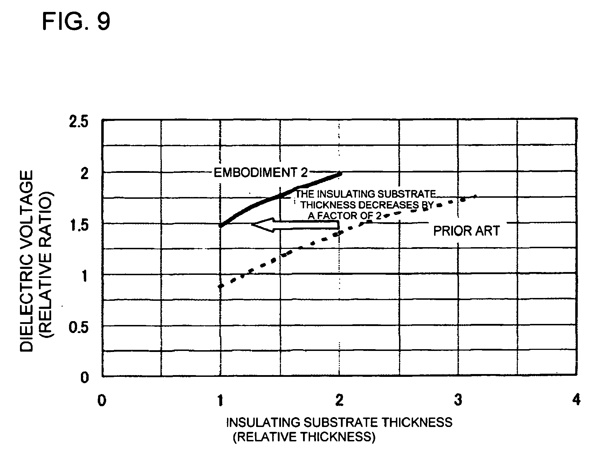

FIG. 9 shows results of an insulation test conducted on a sample in which the same polyamideimide resin as used in Embodiment 1 is applied as the first resin to the peripheral surface portion of the insulating substrate 103. By the coating with the first resin 120, the same insulation tolerance can be obtained with a thickness which is about 1/2 of the insulating substrate 103. As a result of this, it is possible to reduce the thermal resistance of the semiconductor power module.

## Claims

1. A power semiconductor comprising: a metal substrate disposed on a bottom surface thereof; an organic resin member which covers a side surface portion and a top surface portion thereof; an insulating substrate one surface of which is joined to the metal substrate via a first metal circuit foil; and a semiconductor element which is joined to the other surface of the insulating substrate via a second metal circuit foil, wherein the power semiconductor has a third metal circuit foil disposed on the other surface of the insulating substrate, the third circuit metal foil and the semiconductor element are connected by a metal wire, a connection between the semiconductor element and the metal wire is coated with a first resin having insulating properties, and an inflection point on a surface of the first resin covering the connection is present in a position which is closer to the semiconductor element than 1/4 of the section height of the metal wire in the connection.

2. The power semiconductor according to claim 1, wherein the first resin is coated with a second resin.

3. The power semiconductor according to claim 2, wherein the first resin has a larger Young's modulus than the second resin.

4. The power semiconductor according to claim 2, wherein the Young's modulus of the first resin is 1500 to 5000 MPa.

5. The power semiconductor according to claim 2, wherein the first resin is a polyamide resin or a polyamideimide resin.

6. The power semiconductor according to claim 2, wherein the second resin is a silicone gel.

7. The power semiconductor according to claim 1, wherein a peripheral edge portion of the other surface of the insulating substrate is coated with the first resin.

8. The power semiconductor according to claim 1, wherein an insulating substrate surface between the second metal circuit foil disposed on the other surface of the insulating substrate and the third metal circuit foil is coated with the first resin.
